# EUROPEAN PATENT APPLICATION

(11) **EP 4 697 095 A1**
(43) Date of publication of application: **18.02.2026**
(21) Application number: 24194957.7
(22) Date of filing: 16.08.2024
(51) Int. Cl.: G03F 7/00, H05G 2/00

(54) **OPTICAL SYSTEM AND METHOD OF USING OPTICAL SYSTEM**

(71) Applicant: ASML Netherlands B.V., 5500 AH Veldhoven (NL)
(72) Inventor: VAN DEN BRINK, Enno, 5500AH Veldhoven (NL); CHOWDHURY, Yassin, 5500AH Veldhoven (NL); YUAN, Jiayue, 5500AH Veldhoven (NL); SWINKELS, Gerardus, Hubertus, Petrus, Maria, 5500AH Veldhoven (NL); LAVRENTEV, Egor, 5500AH Veldhoven (NL); TYCHKOV, Andrey, Sergeevich, 5500AH Veldhoven (NL); ANANDAN, Krishna Prashanth, 5500AH Veldhoven (NL); BÄUMER, Stefan, Michael, Bruno, 5500AH Veldhoven (NL)
(74) Representative: ASML Netherlands B.V.

(57) **Abstract**

The present invention provides an optical system comprising a plurality of transmissive and reflective elements arranged to transmit light of a unique wavelength from a source to an intended destination. The forward propagating beam follows a path through the transmissive elements and towards a droplet. The forward propagating beam is partially reflected on one or more of the transmissive elements and/or the droplet to form a return beam travelling along a path in a generally opposing direction to the forward propagating beam. The optical system further comprises is configured to estimate an amount of stray ghosting light in the return beam.

## Description

### FIELD

The present invention relates to an optical system, a method of calibrating measurements of the optical system, a method of operating the optical system, and a lithography system comprising the optical system.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses a reflective surfaces instead of a lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

The lithographic apparatus may generate EUV radiation as a result of a forward propagating beam of light being incident on a droplet of fuel. There may be a plurality of optical elements configured to direct and/or transmit the forward propagating beam from the source to the droplet. In order to assess the effectiveness of the impact of the forward propagating beam on the droplet, the apparatus may comprise a return beam detector. The forward propagating beam may be reflected off the droplet as a primary return beam. The return beam detector is configured to detect light of the primary return beam.

The plurality of optical elements may include transmissive elements, for example windows and lenses. Light from the forward propagating beam may undesirably be reflected off one or more of these transmissive elements. These reflections may be referred to as ghost reflections. These ghost reflections may travel back through the optical system towards the return beam detector. The return beam detector may therefore detect light which is not a true representation of the primary return beam. Instead the return beam detector may detect some combination of light of the primary return beam and light of ghost reflections. The measurements taken by the return beam detector may be used to assess effectiveness of the EUV generation and to adjust control inputs to the system if needed. As such, it is desirable to be able to remove, distinguish and/or filter out the ghost reflections, such that a more accurate measurement of the primary return beam may be obtained.

### SUMMARY

It is an object of the present disclosure to provide embodiments of an optical system, a method of calibrating measurements of the optical system, a method of operating the optical system, and a lithography system comprising the optical system.

According to an aspect of the invention, there is provided an optical system comprising a plurality of transmissive and reflective elements arranged to transmit light of a unique wavelength from a source to an intended destination. The source is configured to emit the light as a forward propagating beam. The forward propagating beam follows a path through the transmissive elements and towards a droplet. The forward propagating beam is partially reflected on one or more of the transmissive elements and/or the droplet to form a return beam travelling along a path in a generally opposing direction to the forward propagating beam. The optical system further comprises a controller configured to measure a first amount of light of the return beam when the system is in an OFF-droplet condition, wherein in the OFF-droplet condition the system is configured such that the forward propagating beam is not incident on a droplet. The controller is controller configured to measure a second amount of light of the return beam when the system is in the ON-droplet condition, wherein in the ON-droplet condition the system is configured such that the forward propagating beam is incident on a droplet. The controller configured to estimate an amount of ghosting light based on the first amount of light. The controller configured to calibrate subsequent measurements of the second amount of light taken by the system based on the estimated amount of stray ghosting light.

According to another aspect of the invention, there is provided a method of calibrating measurements of an optical system. The optical system comprises a plurality of transmissive and reflective elements arranged to transmit light of a unique wavelength from a source to an intended destination. The source is configured to emit the light as a forward propagating beam, wherein the forward propagating beam follows a path through the transmissive elements and towards a droplet. The forward propagating beam is partially reflected on one or more of the transmissive elements and/or the droplet to form a return beam travelling along a path in a generally opposing direction to the forward propagating beam. The method comprises measuring a first amount of light of the return beam when the system is in an OFF-droplet condition, wherein in the OFF-droplet condition the system is configured such that the forward propagating beam is not incident on a droplet. The method comprises measuring a second amount of light of the return beam when the system is in the ON-droplet condition, wherein in the ON-droplet condition the system is configured such that the forward propagating beam is incident on a droplet. The method comprises estimating an amount of ghosting light based on the first amount of light. The method comprises calibrating the measurement of the second amount of light taken by the system based on the estimated amount of stray ghosting light.

According to another aspect of the invention, there is provided an optical system comprising a plurality of transmissive elements arranged to transmit light of a unique wavelength from a source to an intended destination. The source is configured to emit the light as a forward propagating beam. The optical system is configured such that the forward propagating beam follows a path through the transmissive elements and towards a droplet. The optical system is configured such that the forward propagating beam is partially reflected on one or more of the transmissive elements to form a ghost reflection. The optical system is configured such that the forward propagating beam is partially reflected on the droplet to form a primary return beam. The primary return beam and the ghost reflection form a return beam travelling along a path in a generally opposing direction to the forward propagating beam. The optical system is configured to distinguish between the primary return beam and the ghost reflection based on curvature of the light of the return beam.

According to another aspect of the invention, there is provided a method of operating an optical system. The optical system comprises a plurality of transmissive elements arranged to transmit light of a unique wavelength from a source to an intended destination. The method includes emitting the light from the source as a forward propagating beam, wherein the forward propagating beam follows a path through the transmissive elements and towards a droplet. The optical system is configured such that the forward propagating beam is partially reflected on one or more of the transmissive elements to form a ghost reflection, and the forward propagating beam is partially reflected on the droplet to form a primary return beam, and the primary return beam and the ghost reflection form a return beam travelling along a path in a generally opposing direction to the forward propagating beam. The method further comprises distinguishing between the primary return beam and the ghost reflection based on curvature of the light of the return beam.

According to another aspect of the invention, there is provided an optical system comprising a plurality of transmissive elements arranged to transmit light of a unique wavelength from a source to an intended destination. The source is configured to emit the light as a forward propagating beam. The optical system is configured such that the forward propagating beam follows a path through the transmissive elements and towards a droplet. The optical system is configured such that the forward propagating beam is partially reflected on one or more of the transmissive elements to form a ghost reflection. The optical system is configured such that the forward propagating beam is partially reflected on the droplet to form a primary return beam. The primary return beam and the ghost reflection form a return beam travelling along a path in a generally opposing direction to the forward propagating beam. The optical system is configured to at least partially suppress the ghost reflection in the return beam.

According to another aspect of the invention, there is provided an optical system comprising a plurality of transmissive elements arranged to transmit light of a unique wavelength from a source to an intended destination. The source is configured to emit the light as a forward propagating beam. The optical system is configured such that the forward propagating beam follows a path through the transmissive elements, such that the forward propagating beam is incident on a droplet. The transmissive elements comprise a polarization means configured to provide a desired polarization to the light being emitted from the source, such that downbeam of the polarization means the forward propagating beam has the desired polarization. The polarization means is disposed such that a number of transmissive elements upbeam of the polarization means is greater than a number of transmissive elements downbeam of the polarization means in a path of the forward propagating beam from the source to the droplet.

According to another aspect of the invention, there is provided an extreme ultraviolet based lithography system comprising the optical system.

### BRIEF DESCRIPTION OF FIGURES

Embodiments of the invention will now be described, by way of example only, with reference to the accompanying schematic drawings, in which:
- Figure 1 depicts a lithographic system comprising a lithographic apparatus and a radiation source;
- Figure 2 depicts an optical system which may be suitable for use as a laser system in the lithographic system of Figure 1;
- Figure 3A depicts part of an optical system in an OFF-droplet condition;
- Figure 3B depicts the part of the optical system of Figure 3A in an ON-droplet condition;
- Figure 4A depicts an image of curvature of light as generated from measurements of a wavefront sensor;
- Figure 4B depicts an image of the amplitudes of curvature of Figure 4A which have been processed using a Fourier transform of order U.
- Figure 5A depicts part of an optical system comprising suppressive optical elements;
- Figure 5B depicts light signals as viewed in cross-sectional through a metrology pane;
- Figures 6A-H depict different suppressive optical elements;
- Figure 7 depicts part of an optical system comprising a suppressive optical element disposed on an actuated support;
- Figure 8 depicts a heat management system which may be provided in an optical system;
- Figure 9 depicts part of an optical system, including a conical-shaped suppressive optical element;
- Figure 10 depicts an intensity distribution of the return beam;
- Figure 11 depicts part of an exemplary optical system of the prior art;
- Figure 12 depicts an optical system comprising a quarter wave plate;
- Figure 13 depicts an optical system comprising an optical element having a coating configured to act as a polarization means;

The schematic diagrams and views show the components described below. However, the components depicted in the figures are not to scale.

### DETAILED DESCRIPTION

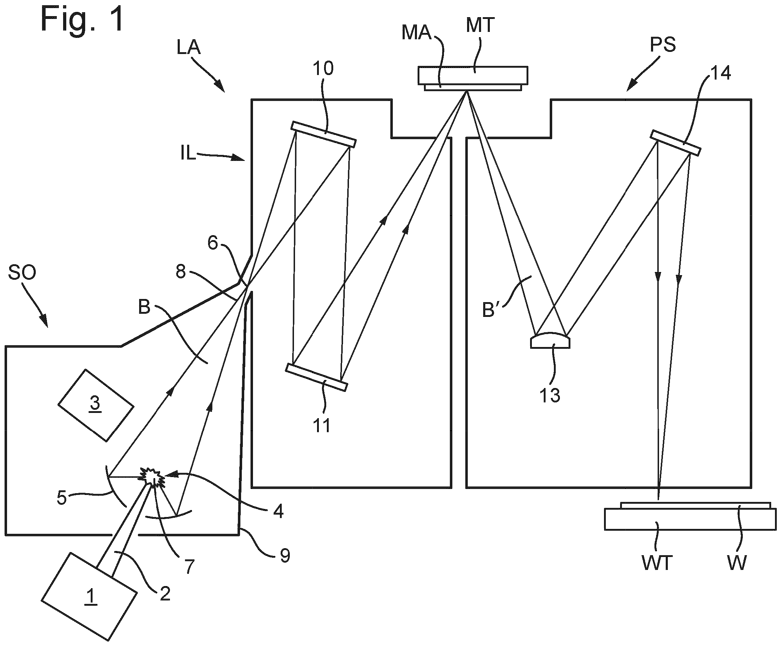

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

As shown in Figure 1, there are applications, such as in a lithographic system, comprising a laser system 1. The laser system 1, which may, for example, include a CO₂ laser, is arranged to deposit energy via a laser beam 2 into a fuel. The laser beam 2 is incident upon the fuel, e.g., in the form of droplets of fuel, at the plasma formation region 4. Similar laser systems 1 may be provided in applications other than lithographic systems.

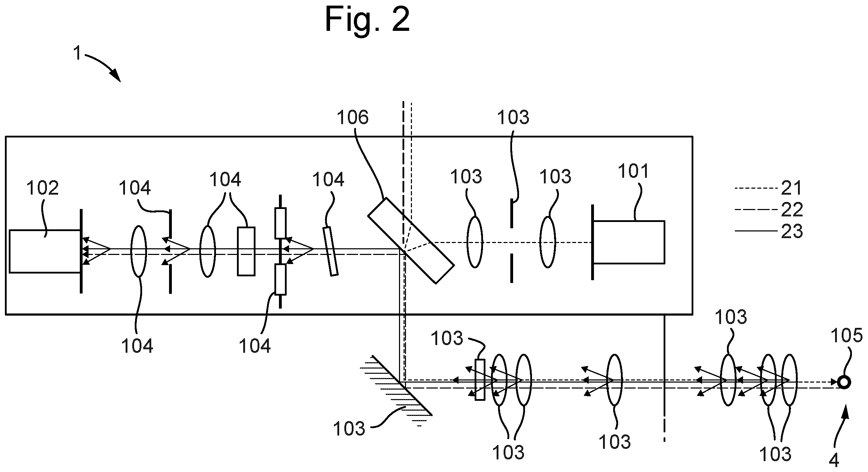

Figure 2 depicts an optical system, which may be a laser system 1 suitable for use in the lithographic system of Figure 1. The laser system 1 of Figure 2 comprises a source 101 and a plurality of optical elements 103. The optical elements are arranged to transmit light of a unique wavelength from the source 101 to the plasma formation region 4. The source 101 is configured to emit the light as a forward propagating beam 21. The forward propagating beam 21 follows a path through the optical elements 103. The laser system 1 is configured such that, when desired during use, the forward propagating beam 21 is incident on a droplet 105 in the plasma formation region 4. In this way, plasma 7 may be formed and EUV radiation from the plasma 7 may be used, for example by a lithographic apparatus LA.

The plurality of optical elements 103 may include reflective elements, for example mirrors. The plurality of optical elements 103 includes transmissive elements, for example windows and lenses. The transmissive elements may be coated with anti-reflection (AR) coatings in order to try to reduce an amount of back reflection, otherwise known as ghost reflections 23. For example, the anti-reflection coatings may have reflectivity values between 0.05% and 0.1%. However, it may not be possible to eliminate ghost reflections 23 entirely.

As shown for example in Figure 2, there may be ghost reflections 23 where the forward propagating beam 21 is reflected off some of the plurality of optical elements 103. These ghost reflections 23 may travel back through the optical system towards the return beam detector 102. The return beam detector 102 may therefore detect not only the primary return beam 22 created by reflection of the forward propagating beam 21 on the droplet 105, but may also, possibly simultaneously, detect the ghost reflections 23. As a consequence, the ghost reflections 23 may contaminate the measurements of the return beam detector 102. In other words, the measurements from the return beam detector 102 may not be a true representation of the primary return beam 22 but may be a return beam formed of some combination of the primary return beam 22 and ghost reflections 23. The measurements taken by the return beam detector 102 may be used to assess effectiveness of the EUV beam B and to adjust control inputs to the system if needed. As such, it is desirable to be able to remove, distinguish and/or filter out the ghost reflections 23 from the return beam reaching the return beam detector 102, such that a more accurate measurement of the primary return beam 22 may be obtained.

In order to achieve good conversion efficiency, the forward propagating beam 21 is desirably focused with high accuracy and precision relative to the droplet 105. To achieve this, a closed-loop control scheme may be implemented. The closed-loop control scheme may make use of measurement of properties of properties of the forward propagating beam 21. The closed-loop control scheme desirably makes use of measurement of properties of properties of a primary return beam 22 caused by the forward propagating beam 21 reflecting back off the droplet 105. A beam-pickup element 106 may be placed in a path of the forward propagating beam 21. The beam-pickup element 106 may direct a sample of the forward propagating beam 21 towards a metrology unit. Measurements of the sampled forward propagating beam 21 taken by the metrology unit may be use by the closed-loop control scheme. Furthermore, the beam-pickup element 106 may direct the primary return beam 22 towards a metrology unit (referred to herein as a return beam detector 102, and otherwise known as Final Focus Metrology, FFM). Measurements of primary return beam 22 taken by the metrology unit may be use by the closed-loop control scheme.

The laser system 1 of Figure 2 comprises a return beam detector 102 and a further plurality of optical elements 104. The return beam detector 102 is configured to detect a return beam. The return beam detector 102 may optionally comprise a wavefront sensor. The primary return beam 22 is a beam reflected off the droplet 105 and transmitted via the further plurality of optical elements 104 to the return beam detector 102. The further plurality of optical elements 104 are desirably disposed such that the forward propagating beam 21 is not incident on any of the further plurality of optical elements 104. In other words, the further plurality of optical elements 104 may be disposed in a path of the return beam and not in a path of the forward propagating beam 21. The measurements taken by the return beam detector 102 may be used to assess whether dose margin and power of the EUV beam B are appropriate or if adjustments are needed. As explained above, this may optionally be implemented as a closed-loop control scheme. It is therefore desirable that the measurements of the return beam detector 102 are reliable and accurate representations of the beam as reflected by the droplet 105. It may be difficult to measure or estimate parameters of the primary return beam 22 accurately and reliably because it may be difficult the primary return beam 22 from ghost reflections 23 in the return beam reaching the return beam detector 102. This may be further complicated by the ghost reflections 23 not being constant, as they may not be readily accounted for by a set calibration. In particular, the ghost reflections 23 may be dependent on other parameters or settings of the optical system, for example power of the forward propagating beam 21.

Wedges or tilting transmissive optical elements may be provided, together with one or more field stops, in an effort to reduce or mitigate the ghost reflections 23 reaching the return beam detector 102. The basic disadvantage of applying wedges or tilting transmissive optical elements in the optical beam path is that the forward propagating beam 21 spatial quality is affected. Astigmatism and coma aberrations are introduced to be forward propagating beam 21 which may distort the intensity profile at droplet 205. This is especially true when larger tilting is required to block the full light cone from the ghost reflections 23. When proper intensity profile at droplet 105 is not achieved, it will influence EUV conversion efficiency and causes EUV power drop. Furthermore, aberration impact also increases with beam size. Hence there will be a larger impact on primary return beam 22 quality compared to forward propagating beam 21 leading to inaccuracy in primary return beam 22 measurement. It is also often difficult to introduce tilt/wedges in the optical design in a mature product due to impact on opto-mechanical design which requires significant re-design. There is therefore a desire to determine an alternative means to reduce or mitigate the influence of ghost reflections 23 on the primary return beam 22 measurement, without compromising spatial quality of the forward propagating beam 21.

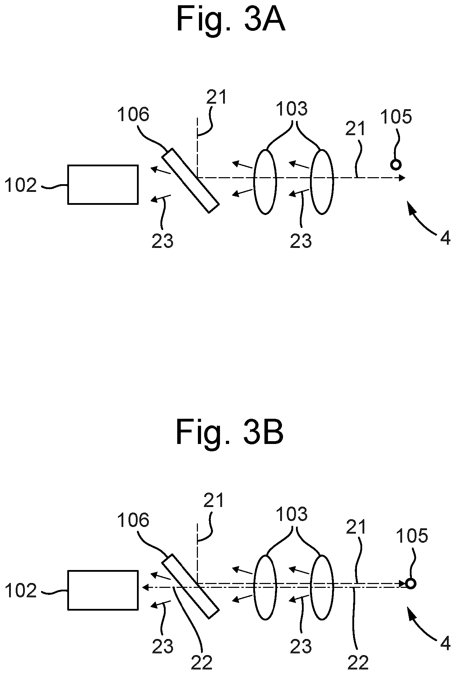

Figures 3A and 3B show part of an optical system 100, which may be a laser system 1 such as that as described above in relation to Figure 2, in different operating conditions. The optical system comprises a plurality of optical elements 103 arranged to transmit light of a unique wavelength from a source 101 to an intended destination, such as the plasma forming region 4. The source 101 is configured to emit the light as a forward propagating beam 21. The optical system 100 is configured such that the forward propagating beam 21 follows a path through the optical elements 103. The forward propagating beam 21 is partially reflected on one or more of the optical elements 103 as ghost reflections 23. In particular, the forward propagating beam 21 may be partially reflected on one of more transmissive elements of the plurality of optical elements 103. The optical system 100 is configured such that, when desired in use, the forward propagating beam 21 is incident on a droplet 105 in the intended destination. The forward propagating beam 21 is partially reflected on the droplet to form a primary return beam 22 travelling along a path in a generally opposing direction to the forward propagating beam 21. The optical system 100 of Figures 3A and 3B comprises a return beam detector 102 configured to detect light of a return beam, which may include ghost reflections 23 and/or the primary return beam 22.

The optical system 100 is configured to be set in an OFF-droplet condition, as shown in Figure 3A. In in the OFF-droplet condition the optical system 100 is configured such that the forward propagating beam 21 is not incident on a droplet 105. In other words, in the OFF-droplet condition the forward propagating beam 21 is not reflected on a droplet 105 such that no primary return beam 22 is created. This may be achieved, for example, by not providing any droplets 105 or by providing droplets 105 at a timing with respect to a timing of the forward propagating beam 21 such that the forward propagating beam 21 does not impact any of the droplets 105. In other words, the droplets 105 are provided at a timing such that the forward propagating beam 21 travels between droplets 105 and is not incident on the droplets 105.

The optical system 100 is also configured to be set in an ON-droplet condition, as shown in Figure 3B. In contrast to the OFF-droplet condition, in the ON-droplet condition the optical system 100 is configured such that the forward propagating beam 21 is incident on a droplet 105. In the ON-droplet condition, a primary return beam 22 may therefore be created by the forward propagating beam 21 being at least partially reflected on the droplet 105.

An amount of light, corresponding to ghost reflections 23, which is incident on the return beam detector 102 may by determined based on a measurement by the return beam detector 102 in the OFF-droplet condition. This is because in the OFF-droplet condition the return beam which is incident on the return beam detector 102 may include ghost reflections 23 but does not include a primary return beam 22. Similarly, an amount of light, corresponding to a combination of both the ghost reflections 23 and the primary return beam 22, which is incident on the return beam detector 102 may by determined based on a measurement of the return beam detector 102 in the ON-droplet condition. This is because in the ON-droplet condition the return beam which is incident on the return beam detector 102 may include ghost reflections 23 as well as a primary return beam 22.

The amount of light corresponding to the primary return beam 22 in the ON-droplet condition may then be estimated by accounting for the amount of light corresponding to ghost reflections 23 (where the amount of light corresponding to ghost reflections 23 estimated based on the measurement of the return beam incident on the return beam detector 102 in the OFF-droplet condition). In other words, a measurement of the ghost reflections 23, as measured in the OFF-droplet condition, may be subtracted from a measurement including both ghost reflections 23 and the primary return beam 22, as measured in the ON-droplet condition, in order to determine an estimated measurement of the primary return beam 22. In this way, the primary return beam 22 may be measured more accurately than if the ghost reflections 23 were not taken into account.

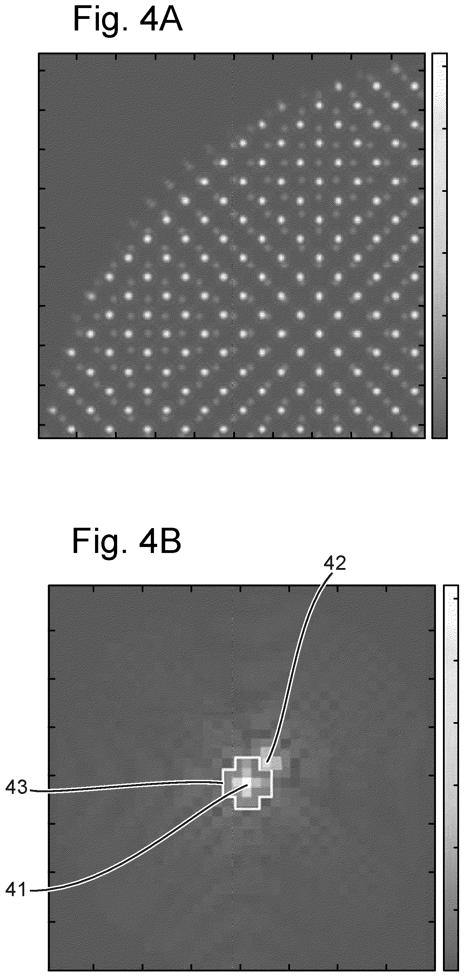

In order to implement the above-described process to estimate the light of the primary return beam 22, the optical system 100 may comprises a controller (not shown in Figure 3A and 4B). The controller may be configured to receive a measurement of a first amount of light of the return beam when the system is in the OFF-droplet condition. The controller may be configured to measure a second amount of light of the return beam when the system is in the ON-droplet condition. The controller is desirably configured to estimate an amount of ghosting light, corresponding to ghost reflections 23, based on the first amount of light. The controller may be configured to calibrate measurements of the second amount of light taken by the system based on the estimated amount of stray ghosting light. In other words, the controller may be configured to estimate the amount of light of the primary return beam 22 by calibrating measurements of the second amount of light based on the estimated amount of stray ghosting light. This may be done by subtracting the first amount of light from the second amount of light.

It is therefore possible to use measurements taken in the OFF-droplet condition to determine a measured value, which may be considered as a calibration value, associated with the ghost reflections 23. The calibration value of the ghost reflections 23 may be subtracted from measurements take in the ON-droplet condition in order to estimate a corresponding value of the primary return beam 22. It is desirable that there is no change to the system between the OFF-droplet condition, used to determine a calibration value, and the ON-droplet condition, to which that calibration value is applied, other than the forward propagating beam 21 being incident or not on the droplet 105. If other changes were made between the OFF- and ON- droplet conditions it would be unclear whether a difference in measurements of the return beam detector 102 between the OFF- and ON- droplet conditions were caused only by the presence of the primary return beam 22 in the ON- droplet conditions or if there was a change in the light of the ghost reflections 23. For example, if the measurement in the OFF-droplet condition were taken to obtain a correction value, and then a power of the forward propagating beam 21 were changed such that it was different when taking the corresponding measurement in the ON-droplet condition, the correction value would likely be an inaccurate representation of the influence of the ghost reflection 23 in the ON-droplet condition because the light of the ghost reflections 23 would be influenced by the change in power of the forward propagating beam 21.

If the settings of the system are to be adjusted, the comparison of return beam detector 102 in the OFF-droplet conditions may be repeated. In other words, a measurement may be taken in the OFF-droplet condition with the new settings applied in order to obtain a new calibration value, associated with the measurement of light of the ghost reflections 23 when the system has the new setting applied. The new calibration value may then be applied in order to calibrate the measurement of the return beam detector in the ON-droplet condition, to estimate the light of the primary return beam 22.

It may be desirable to perform measurements in the OFF-droplet condition for a plurality of different settings in order to obtain corresponding calibration values, associated with the light of the ghost reflections 23. The required corresponding calibration value may then be applied to measurements taken by the system in the ON-droplet condition with the corresponding settings. Alternatively, or additionally, the calibration values obtained for the different settings may be used to determine a relationship between the settings and the calibration values such that calibration values for different settings may be readily estimated.

The controller may be configured to receive a measurement a plurality of first amounts of light corresponding to different parameter values of the forward propagating beam 21. The controller may be considered to receive a measurement a plurality of second amounts of light corresponding to the different parameter values of the forward propagating beam 21. The controller may be configured to estimate the amount of stray ghosting light based on each corresponding first amount of light. The controller may be configured to calibrate subsequent measurements of the second amount of light corresponding to the different parameter values taken by the system based on the estimated amount of stray ghosting light. For example, the parameter values may correspond to the power of the forward propagating beam 21. In other words, the controller may be configured to calibrate subsequent measurements of the second amount of light corresponding to the different parameter values taken by the system based on the estimated amount of stray ghosting light as function of power of the forward propagating beam. Alternatively, or additionally, the parameter values may correspond to drift of the forward propagating beam 21. In other words, the controller may be configured to calibrate subsequent measurements of the second amount of light corresponding to the different parameter values taken by the system based on the estimated amount of stray ghosting light as function of amount of forward propagating beam drift. Alternatively, or additionally, the parameter values may correspond to actuation angle of the forward propagating beam 21. In other words, the controller may be configured to calibrate subsequent measurements of the second amount of light corresponding to the different parameter values taken by the system based on the estimated amount of stray ghosting light as function of amount of forward propagating beam actuation angle.

Alternatively, or additionally, the parameter values may correspond to different control applied to the forward propagating beam 21 subsequent to the droplet 105. In other words, the controller may be configured to calibrate subsequent measurements of the second amount of light corresponding to the different parameter values taken by the system based on the estimated amount of stray ghosting light as function of control applied to the forward propagating beam subsequent to the droplet. The control applied to the forward propagating beam 21 subsequent to the droplet 105 may be one or more of a change of one or more of power, curvature, pointing and/or positioning of the forward propagating beam 21.

In some scenarios, it may be preferable to perform the OFF-droplet measurement when using the system in the ON-droplet condition such that there is a reduced likelihood of an unknown change decreasing the integrity of the calibration values. In other words, it is desirable to obtain a calibration value for each session using the system or when changing the settings of the system during a session. For example, each time the system is used or a setting of the system is changed, the system may be run in an OFF-droplet condition to obtain a calibration value to be applied to measurements taken in the corresponding ON-droplet condition.

As described above, for example in reference to the system of Figure 2, there is a problem that it can be difficult to measure the primary return beam 22 because ghost reflections 23 may also be present in the return beam incident on the return beam detector 102. It is therefore desirable to be able to filter the measurement of the return beam to remove contributions from light of the ghost reflections 23 such that a more accurate representation of the primary return beam 22 may be obtained.

In some circumstances, the primary return beam 22 may have a relatively flat wavefront in comparison to a wavefront of the ghost reflections 23. In other words, curvature of light of the primary return beam 22 may be close to zero. The light of the ghost reflections 23 may have a larger magnitude of curvature. For example, the light of the ghost reflections 23 may have a larger magnitude of curvature greater than 2 1/m, possibly greater than 3 1/m. The optical system 100, such as that described above in reference to Figure 2, may be configured to distinguish between the primary return beam 22 and the ghost reflection 23 based on curvature of the light of the return beam. Where the return beam includes the primary return beam 22 and the ghost reflection 23.

Figure 4A provides an image of curvature of light as generated from measurements of a wavefront sensor. Figures 4B shows the amplitudes of curvature which have been processed using a Fourier transform of order U. In other words, a Fourier transform transmission mask has been applied to the data of Figure 4A in order to arrive at the masked result shown in Figure 4B. In Figure 4B, the primary return beam 22, which has curvature close to zero, shows as a peak intensity region, otherwise referred to as a primary region 41, in Fourier space in the center of the U mask. In Figure 4B, light of the ghost reflection 23 is represented as a secondary peak of intensity, otherwise referred to as a ghost satellite region 42, in Fourier space. The ghost satellite region 42 in Fourier space is at a greater distance from the center of the U mask than the primary region 41 is from the from the center of the U mask because the light of the ghost reflection 23 has a large curvature delta with respect to light of the primary return beam 22.

This difference between the curvature of the light of the ghost reflection 23 and light of the primary return beam 22 may be used to filter out the ghost reflections 23. In particular, considering the measurements, masked using Fourier transform of order U as shown in Figure 4B, the peak intensity may be identified and a border 43 around that peak may be established. Pixels of the image falling outside the border 43 may be filtered out. This means that pixels of the primary region 41, corresponding to the light of the primary return beam 22, will be retained while pixels of the ghost satellite region 42, corresponding to the light of the ghost reflections 23, may be filtered out and not considered in further analysis of the data. In this way, a more accurate measurement of the light of the primary return beam 22 may be obtained.

An optical system, which may be an optical system 100 as described above with respect to Figure 3A and 3B, may further comprise a wavefront sensor configured to measure an optical wavefront of the light of the return beam. The optical system 100 may comprise a controller configured to receive image data based on measurements from the wavefront sensor. As shown, for example, in Figure 4B, the image data preferably comprises data of a plurality of pixels. Each pixel, of the plurality of pixels is associated with a respective amplitude of the Fourier transform of measurement from the wavefront sensor. The controller is desirably configured to normalize the amplitudes associated with the pixels in the image. The controller is desirably configured to find the pixel having the greatest amplitude. In other words, the pixel corresponding to the peak intensity, or greatest amplitude, may be identified.

The controller may be configured to set a predetermined radius, or border 43, around the pixel identified as having the greatest amplitude. The predetermined radius is set such that pixels outside the predetermined radius correspond to a curvature of light having a magnitude greater than a threshold curvature. The threshold curvature may be 4 1/m, desirably 3 1/m, more desirably 2 1/m. The controller may be configured to identify pixels which are outside of the predetermined radius. The controller may then filter out data associated with the pixels identified as being outside of the predetermined radius. The identified pixels may include pixels of the ghost satellite region 42. In other words, the controller may enable the data corresponding to ghost reflections 23 to be filtered out, while retaining the data associated with pixels of the primary region 41 corresponding to the primary return beam 22. Filtering out data associated with the identified pixels may optionally comprise setting the amplitude of the identified pixels to zero.

The controller is optionally configured to identify pixels which have an amplitude greater than a predetermined threshold. In particular, the controller may identify pixels which are both outside the border 43 and which have an amplitude greater than the predetermined threshold. In this way, the pixels corresponding to the ghost satellite region 42 of the image may be identified to be filtered out, without also filtering out data corresponding to pixels outside the border 43 and having low amplitude. This is beneficial because the low amplitude pixels may not correspond to the ghost satellite region 42 and thus may not correspond to date of light of the back reflections 23. It may therefore be desirable to retain the date of these low amplitude pixels and not filter them out. The controller may be configured, after setting the predetermined radius, to set the amplitude of pixels within the predetermined radius to zero. In this way, any pixels remaining in the image and having an amplitude greater than the predetermined threshold amplitude can be readily identified for filtering out.

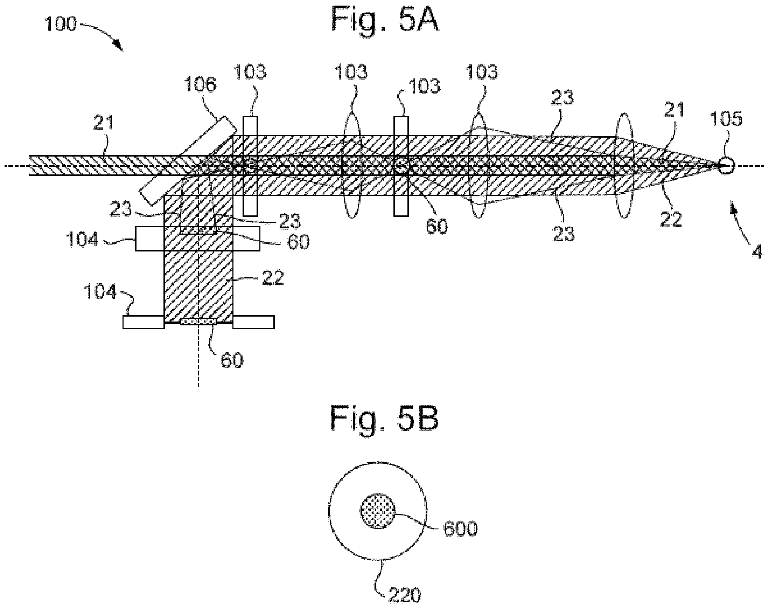

Figure 5A depicts part of an optical system 100, which may be part of a laser system 1 such as that of Figure 2, as described above. The optical system 100 comprises a plurality of optical elements 103, including transmissive elements, arranged to transmit light of a unique wavelength from the source 101 to an intended destination. The intended destination may be a plasma formation region 4. The source 101 is configured to emit the light as a forward propagating beam 21. The forward propagating beam 21 follows a path through the transmissive elements 103. The optical system 100 is configured such that, when desired during use, the forward propagating beam 21 is directed towards a droplet 105. The forward propagating beam 21 may be partially reflected on one or more of the transmissive elements to form a ghost reflection 23. The forward propagating beam 21 is partially reflected on the droplet 105 to form a primary return beam 22. The primary return beam 22 and the ghost reflection 23 travel along a path in a generally opposing direction to the forward propagating beam. In other words, a return beam directed towards the return beam detector 102 may be comprised of the primary return beam 22, which is the beam intended to be detected by the return beam detector 102, and some unwanted ghost reflections 23.

The optical system 100 of Figure 5A is configured to at least partially suppress the ghost reflection 23. In other words, the optical system 100 is configured to block ghost reflections 23, filter out block ghost reflections 23, deflect ghost reflections 23, and/or reduce a power of ghost reflections 23, such that the ghost reflections 23 received by the return beam detector 102 may be reduced. With an arrangement such as this, the ghost reflections 23 may be substantially suppressed or blocked while the primary return beam 22 may be substantially transmitted to the return beam detector 102. Figure 5B provides an illustration of light signals as viewed in cross-sectional through a metrology pane X of Figure 5A. In other words, Figure 5B provides an illustration of the return beam as received by the return beam detector 102. The return beam as received by the return beam detector 102 includes sufficient information 220 of the primary return beam 22 while having a blocked region 660 caused by the suppression of the ghost reflections 23. This arrangement may therefore provide the benefit of enabling the primary return beam 22 to be measured with greater accuracy due to suppression of the ghost reflections 23. Furthermore, the forward propagating beam 21 is desirably not significantly suppressed by the optical system 100.

As shown in Figure 5A, the optical system 100 may, for example, comprise at least one optical element 60 (which may be referred to as a suppressive optical element) configured to at least partially suppress the light of the ghost reflection 23 without entirely suppressing the light of the primary return beam 22. The suppressive optical element 60 is desirably disposed to provide suppression at a beam waist location at which light of the ghost reflection 23 is incident. In this way, the ghost reflections 23 may be suppressed such that their influence on the measurement of the return beam detector 102 is reduced and a more accurate measurement of the primary return beam 22 may be obtained.

The ghost reflections 23 may have large curvatures, relative to curvature of the primary return beam 22. The beam waist location of the ghost reflections 23 may therefore be different than a beam waist location of the primary return beam 22. The beam waist location, at which the at least one suppressive optical element 60 may provide suppression, is desirably a location at which light of the primary return beam 22 is not incident. This is because it is desirable that the suppression of the primary return beam 22 by the suppressive optical element 60 is less, more desirably significantly less, than the suppression of the ghost reflection 23 by the suppressive optical element 60. In this way, the ghost reflections 23 reaching the return beam detector 102 may be reduced without excessive reduction of the primary return beam 22.

In some circumstances, it may not be practical to locate the suppressive optical element 60 at a beam waist location of one or more ghost reflections 23. It is desirable that the suppressive optical element 60 be as close as possible to the beam waist location. If the suppressive optical element 60 is not located at the beam waist location, the size of the suppressive optical element 60 may be increased in order to achieve comparable levels of suppression to a smaller suppressive optical element 60 located at the beam waist location.

The suppressive optical element 60 may be configured to suppress the ghost reflections 23 by any appropriate mechanism of light suppression. For example, the suppressive optical element 60 may be configured to absorb and/or diffract and/or reflect and/or scatter light of the ghost reflection 23. The suppressive optical element 60 may comprise or consist of an optical black light absorbing element configured to block light of the ghost reflection 23. The suppressive optical element 60 may comprise or consist of a filter configured to filter out light of the ghost reflection 23. In other words, the size of the suppressive optical element 60 may be selected based on the propagation of ghost reflections 23 at the position of the suppressive optical element 60.

The suppressive optical element 60 may applied, e.g., as a coating, to one, or more, of the plurality of optical elements 103, 104 of the optical system 100. For example, suppressive optical element 60 may comprise or consist of an optical black light absorbing coating configured to block light of the ghost reflection 23. The optical element 60 may optionally be disposed on one of the transmissive elements. In this way, the suppressive optical element 60 may be provided without adding to the number of total components in the system, as the suppressive optical element 60 may be part of an optical element 103, 104 which is provided for another purpose in the optical system 100. The suppressive optical element 60 may therefore be provided in an efficient and cost-efficient manner, without taking up too much of the limited space. Alternatively, or additionally, the suppressive optical element 60 may be provided at a beam waist location in an optical window.

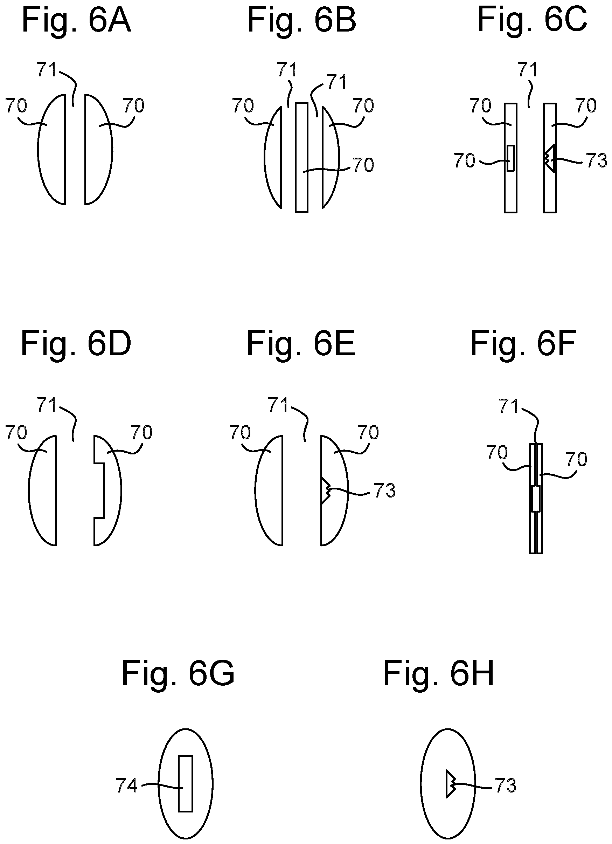

Figures 6A-H show examples of different suppressive optical elements 60. The suppressive optical element 60 may comprises a diffraction structure configured to diffract light of the ghost reflection 23. The diffraction structure may, for example, be a linear grating or a circular grating or a phase grating configured to diffract light of the ghost reflection 23.

As shown, for example, in Figures 6A-F, the diffraction structure may comprise or consist of a lens which is comprised of a plurality of parts 70 separated by parallel gaps 71. The lens may be an optical element of the plurality of optical elements 103, 104. In particular, the lens may be an optical element 103, 104 which is a transmissive element. As shown, for example, in Figures 6A, 6B, 6D and 6E, the lens may be a convex lens. The plurality of parts 70 may optionally include a central part disposed between at least two other parts, as shown for example in Figure 6B. The central part may comprise or consist of a further optical element configured to at least partially suppress the light of the ghost reflection 24 without entirely suppressing the light of the primary return beam 22. The further optical element may, for example, comprise or consist of an optical black configured to block the light of the ghost reflection 23.

In another arrangement, such as shown in Figures 6C, 6E, and 6H, the suppressive optical element 60 may be disposed on or within an optical element of the plurality of optical elements 103, 104. The optical element may, for example, comprise or consist of an optical black configured to block the light of the ghost reflection 23. Alternatively, the optical element may comprise or consist of a tilted reflective surface 73 or an internal wedge 72. The tilted reflective surface 73 or internal wedge 72 is desirably configured to reflect light of the ghost reflection 23 in a pre-defined direction. In particular, the pre-defined direction may be a direction which leads the ghost reflections 23 along a different path than the path of the primary return beam 22.

In another arrangement, such as shown in Figures 6G, the suppressive optical element 60 may be a fluid 74 disposed within an optical element of the plurality of optical elements 103, 104. The fluid 74 may be a gas or a liquid. The suppressive optical element 60 within an optical element of the plurality of optical elements 103, 104 may be manufactured using any suitable method. For example, an arrangement, such as that of Figure 6H, wherein a reflective surface 73 is formed on the inside of the optical element may be created by forming surfaces, similar to the surfaces of parts 70 of Figure 6E, and bonding the surfaces together. The surfaces of the suppressive optical element 60 may be formed, for example, by selective laser etching or laser drilling.

The optical system 100 further comprising a plurality of optical elements 103, 104, wherein more than one optical element 103, 104 is configured to at least partially suppress the light of the ghost reflection 23 without entirely suppressing the light of the primary return beam 22. In other words, the suppressive function may be shared among a plurality of optical elements, rather than being provided by a single suppressive optical element 60. Optionally, each optical element 103, 104 of the plurality of optical elements 103, 104 may be configured to at least partially suppress the light of the ghost reflection 23 without entirely suppressing the light of the primary return beam 22.

The plurality of suppressive optical elements 60 may comprises at least one suppressive optical element 60 corresponding to each transmissive element in the path of the forward propagating beam 21. This may be a desirable arrangement because each transmissive element may generate an associated ghost reflection 23. Thus, each transmissive element having a corresponding suppressive optical element 60 may significantly reduce, or even eliminate, ghost reflections 23.

The suppressive optical element 60 may be configured to be actuated. For example, the suppressive optical element 60 may be moved to a position which enables the light of the ghost reflection 23 to be more effectively suppressed than in if the suppressive optical element 60 were at a different position. This may enable the optical system to be more adaptable, because the suppressive optical element 60 may be moved to a different location as needed, for example to adapt to a change in the beam waist location of the ghost reflections 23.

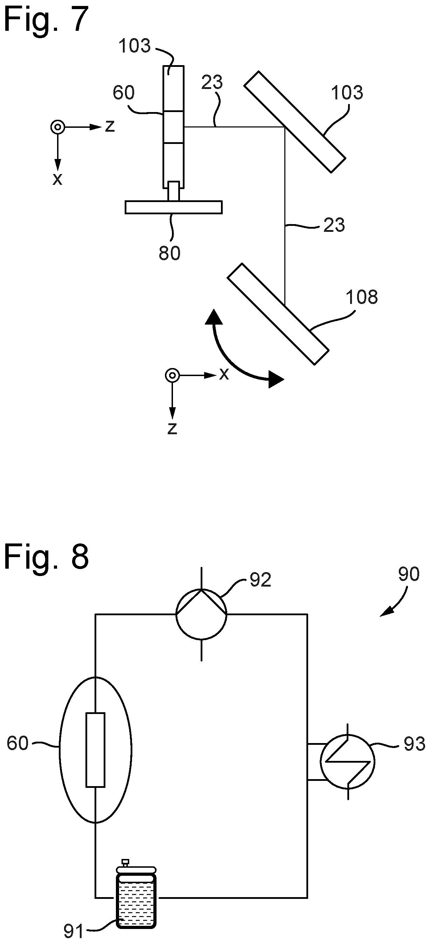

In one arrangement, as shown in Figure 7, the suppressive optical element 60 may be disposed on an actuated support 80. The actuated support 80 may be configured to move in one or more directions. The actuated support 80 may comprise or consist of a motorised stage. As shown in Figure 7, the suppressive optical element 60 is desirably configured to be actuated in at least one translational direction (for example, the local Z-direction of suppressive optical element 60 of Figure 7). The suppressive optical element 60 may be configured to be actuated in two or three translational direction. Alternatively, or additionally, the suppressive optical element 60 is optionally configured to be actuated in at least one rotational direction.

In a preferred arrangement, the suppressive optical element 60 may be configured to be actuated based on a change of path of the forward propagating beam 21. The suppressive optical element 60 may be configured to be actuated automatically based on a change of path of the forward propagating beam 21. A change of path of the forward propagating beam 21 is likely to result in a change of path of the resulting ghost reflections 23. It is therefore desirable that movement of the suppressive optical element 60 may be based on the change of path of the forward propagating beam 21.

Additionally, or alternatively, to the suppressive optical element 60 being configured to be actuated, one or more other optical element 108 (which may be referred to as an actuated optical element 108) of the plurality of optical elements 103, 104 may be configured to be actuated. The actuated optical element 108 may be configured to be actuated in one or more translational directions. In the arrangement of Figure 7, the actuated optical element 108 may be configured to be actuated in one or more rotational directions (e.g., rotation about the local Y axis of the actuated optical element 108 of Figure 7). The actuated optical element 108 may be configured to be actuated based on a change of path of the forward propagating beam 21. The actuated optical element 108 is desirably moved in order to adjust a path of the ghost reflections 23 such that the ghost reflections 23 are more likely to be incident on the suppressive optical element.

The optical system 100 may further comprise a controller (not shown) configured to control a power and/or path of the forward propagating beam 21. The suppressive optical element 60 and/ or the actuated optical element 108 may be configured to be actuated based on feedback from the controller.

The optical system 100 may further comprise a heat management system 90, such as that shown in Figure 8. The heat management system 90 may desirably mitigate heat load in the optical system 100 and particularly reduce the likelihood of the suppressive optical element 60 becoming overheated. In some scenarios, the suppressive optical element 60 may be placed in a path of the forward propagating beam 21. In this condition, due to focusing effect, there could be large heat load on this optical element, which may be one of the plurality of optical elements 103. The optical performance of the suppressive optical element 60 may be reduced if the suppressive optical element 60 becomes overheated. It is therefore desirable that the temperature of the suppressive optical element 60 may be managed.

The heat management system 90 of Figure 8 is configured to reduce the temperature of the suppressive optical element 60. The heat management system 90 may be configured to circulate fluid to reduce the temperature of the optical element 60. The fluid may be a gas or a liquid. For example, the fluid may comprise or consist of water, mercury or tin. The fluid is desirably mercury due to the relatively high absorption properties of mercury around 1 µm, which is a likely wavelength of the ghost reflections 23.

In the arrangement of Figure 8, the heat management system 90 comprises a pump 92 configured to pump fluid around a fluid circulation system. The fluid circulation system directs the fluid to flow through or adjacent to the suppressive optical element 60, in order to reduce the temperature of the suppressive optical element 60. The heat management system 90 of Figure 8 further comprises a heat exchanger 93. The fluid circulation system may then direct the fluid, which has been used to cool the suppressive optical element 60 to the heat exchanger 93. The heat exchanger 93 is desirably configured to reduce a temperature of the fluid. For example, the heat exchanger 93 may be configured to direct heat away from the optical elements 103 of the optical system 100, and in particular to direct heat away from the suppressive optical element 60. The heat management system 90 may further comprise a tank 91 configured to store fluid. The tank 91 may be provided in the path of the fluid circulation system. The tank 91 is desirably configured to store fluid before the fluid is pumped past the suppressive optical element 60.

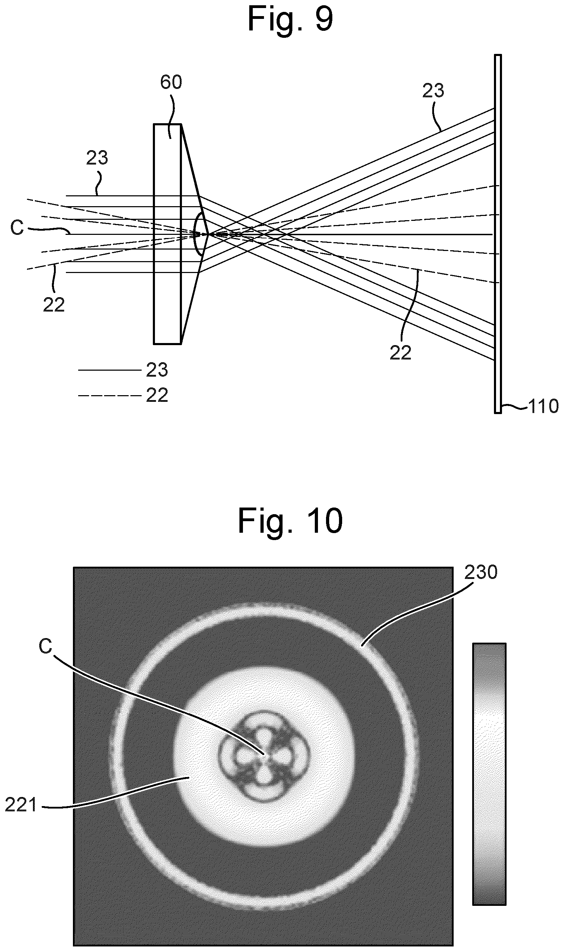

Figure 9 shows a view of part of an optical system 100, including the suppressive optical element 60. The suppressive optical element 60 of Figure 9 is configured to deflect light of the ghost reflection 23 in a different direction than light of the primary return beam 22. The light of the ghost reflection 23 has a higher curvature than the light of the primary return beam 22. Therefore, the curvature of the light may be used to distinguish the ghost reflections 23 from the primary return beam 22.

In the arrangement of Figure 9, the suppressive optical element 60 is a conical element, for example an axicon lens. A conical element, such as an axicon lens, may be configured to deflect beams with larger curvatures, such as the ghost reflections 23, and not dramatically affect beams with smaller curvatures, such as the primary return beam 22. The magnitude of deflection caused by the suppressive optical element 60 may depend on an angle of the conical surfaces of the conical element and/or and index of refraction. In an alternative arrangement, the suppressive optical element may be a collective lens or a split image prism.

In one arrangement (not shown) the suppressive optical element 60 may be configured to deflect light of the ghost reflection 23 to exit the suppressive optical element 60 at an angle to the optical axis C smaller than an angle optical axis at which the light of the primary return beam 22 exits the suppressive optical element 60. In a preferred arrangement, such as is shown in Figure 9, the suppressive optical element 60 is configured to deflect light of the ghost reflection 23 to exit the suppressive optical element 60 at an angle to the optical axis C greater than an angle optical axis at which the light of the primary return beam 22 exits the suppressive optical element 60. Furthermore, in arrangement of Figure 9, an intermediate imaging plate 110 (otherwise referred to as a field stop) is disposed directly downbeam (in a direction of travel of the return beam) of the suppressive optical element 60. The intermediate imaging plate 110 is preferably adjacent to the suppressive optical element 60. In other words, the intermediate imaging plate 110 is preferably the closest optical element 103, 104 to the suppressive optical element 60 that is downbeam (in a direction of travel of the return beam) from the suppressive optical element 60. The magnitude of deflection may depend on a distance between the suppressive optical element 60 and the intermediate imaging plate 110.

Figure 10 illustrates an intensity distribution of the return beam at the intermediate imaging plate 110. Figure 10 shows an outer ring 230 of intensity, at a distance from the optical axis C. The outer ring 230 is an intensity caused by the light defected by the suppressive optical element 60. The outer ring 230 corresponds predominantly to ghost reflections 23. Figure 10 shows an inner region 221 of high intensity closer to the optical axis C than the outer ring 230. The inner region 221 corresponds predominantly to the primary return beam 22.

The intermediate imaging plate 110 may be configured to block the light at a greater distance from the optical axis C without blocking light closer to the optical axis C. In other words, the light corresponding to the outer ring 230 may be blocked, e.g., by a structure such as a plate or field stop, while an aperture may be provided to permit the light corresponding to the inner region 221 to pass unhindered. The intermediate imaging plate 110 may be configured to at least partially, and desirably entirely, block the ghost reflections 23 without significantly blocking the primary reflection beam 22 closer to the optical axis C. In a preferred arrangement, the intermediate imaging plate 110 may be configured such that it does not obstruct the primary reflection beam 22. In other words, the entire primary reflection beam 22 may pass freely through the intermediate imaging plate 110, without being obstructed, filtered or suppressed. The arrangement of Figure 9 is therefore potentially advantageous because the ghost reflections 23 may be significantly reduced, or possibly eliminated, from the return beam prior to measurement by the return beam detector 102, without significantly affecting the primary return beam 22.

The suppressive optical element 60 is preferably one of the further plurality of optical elements 104, where the further plurality of optical elements 104 are disposed in a path of the return beam and not in a path of the forward propagating beam 21. In other words, the suppressive optical element 60 is desirably disposed at a location in a path of the return beam but outside a path of the forward propagating beam 21. In this way, the forward propagating beam 21 may not be re-directed, adjusted, inhibited or suppressed by the suppressive optical element 60. The suppressive optical element 60 may therefore be configured to effectively re-direct the ghost reflections 23 without risk of adverse effects on the forward propagating beam 21.

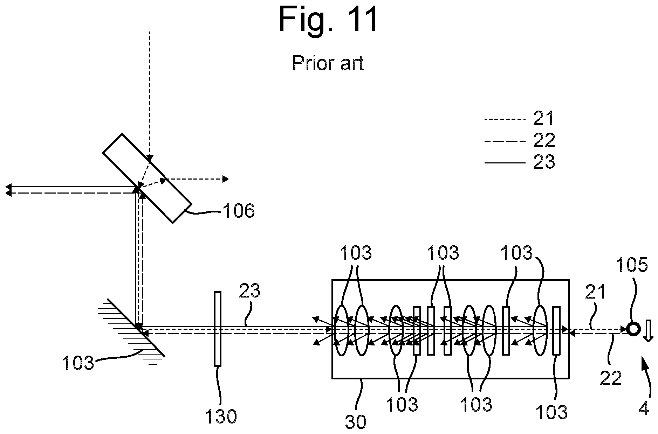

Figure 11 depicts part of an optical system of the prior art (i.e., a known optical system), which may be a laser system 1 such as that of Figure 2, as described above. Similarly to the laser system 1 of Figure 2, the optical system of Figure 11 comprises a source 101 (not shown in Figure 11) and a plurality of optical elements 103. The optical elements are arranged to transmit light of a unique wavelength from the source 101 to an intended destination. The intended destination may be the plasma formation region 4. The source 101 is configured to emit the light as a forward propagating beam 21. The forward propagating beam 21 follows a path through the optical elements 103. The optical system is configured such, when desired during use, the forward propagating beam 21 is incident on a droplet 105 in the plasma formation region 4. The laser system 1 of Figure 11 further comprises a return beam detector 102 (not shown in Figure 11). The return beam detector 102 is configured to detect a primary return beam 22. The primary return beam 22 is a beam reflected off the droplet 105 and transmitted to the return beam detector 102.

The plurality of optical elements 103 may include reflective elements, for example mirrors. The plurality of optical elements 103 includes transmissive elements, for example windows and lenses. As shown for example in Figure 2, there may therefore be ghost reflections 23, otherwise known as ghost reflections, where the forward propagating beam 21 is reflected off some of the plurality of optical elements 103. These ghost reflections 23 may travel back through the optical system towards the return beam detector 102. The power of the primary return beam 22 may be relatively low and have the same or similar order of magnitude as the ghost reflections 23. It may be difficult to distinguish the ghost reflections 23 from the primary return beam 22.

For plasma-efficiency purposes, the forward propagation beam 21 is circularly polarized when it is incident on the droplet 105. The desired polarization provided by the polarization means 130 is desirably a circular polarization. Because the droplet 105 acts as reflector, the reflected primary return beam 22 signal is still circularly polarized (but in an opposing direction relative to the forward propagating beam 21, e.g., clockwise/anticlockwise). To enhance the primary return beam 22 signal levels for metrology, the beam-pickup element 106 may be a polarization-based beam-splitter. Considering the above aspects together, on incidence with the beam-pickup element 106, the forward propagating beam 21 is desirably linearly polarized (e.g., p-polarized). Whereas, on incidence with the beam-pickup element 106, the primary return beam 22 is desirably circularly polarized (e.g., s-polarized). To achieve this, in the arrangement of Figure 11, the system further comprises a polarization means 130. The polarization means 130 is provided in a path of the forward propagating beam 21 downbeam (in a direction of travel of the forward propagating beam 21) of the beam-pickup element 106.

The polarization means 130 is configured to provide a polarization to the light being emitted from the source 101. In other words, the polarization means 130 is configured to provide a polarization to the forward propagating beam 21. The polarization means 130 may comprise or consist of a quarter wave plate. The polarization means 130 is configure such that downbeam (in a direction of travel of the forward propagating beam 21) of the polarization means 130 the forward propagating beam 21 has a desired polarization, e.g., circular polarization.

In the arrangement of Figure 11, the polarization means 130 is provided at a position upbeam (relative to a direction of travel of the forward propagating beam 21) of an optical assembly 30 comprising a plurality of the optical elements 103, including transmissive elements. This means that any light reflected off the optical elements 103 of the optical assembly 30 as ghost reflections 23 will have the same polarization as the actual primary return beam 22. Therefore, the ghost reflections 23 and primary return beam 22 cannot be distinguished from each other based on polarization.

As the forward propagating beam 21 and primary return beam 22 are identified for measurement based on polarization at the beam-pickup element 106, in order to reduce the impact of unwanted ghost/back reflections 23 on the measurement of the primary return beam 22, the polarized state of the ghost reflections 23 would preferably not be the same as polarized state of the primary return beam 22.

In the known arrangement of Figure 11, the polarization means 130 is included as the first transmissive element following the beam-pickup element 106. This means that all the transmissive elements after the polarization means 130 will have circular polarized light incident on their surfaces. The polarization of ghost reflections 23 at all surfaces will be the same state as primary return beam 22. This creates a scenario of significant detrimental impact since the ghost reflections 23 and primary return beam 22 cannot be distinguished by polarization at the beam-pickup element 106.

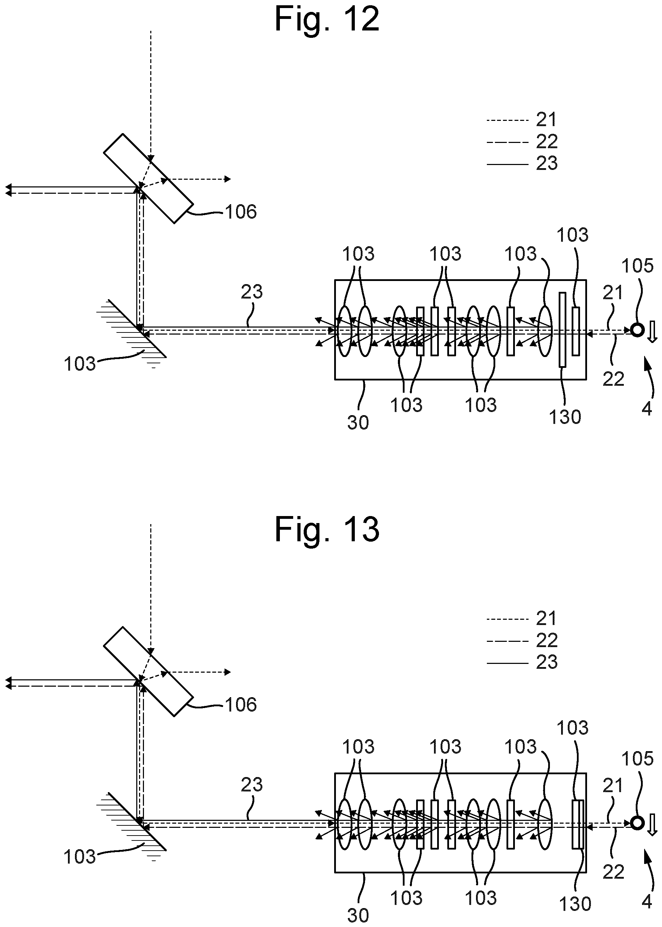

Figure 12 provides an embodiment of an optical system which is the same as that as described above with respect to Figure 11, except that in the arrangement of Figure 12 the polarization means 130 is disposed such that a number of transmissive elements upbeam (relative to a direction of travel of the forward propagating beam 21) of the polarization means 130 is greater than a number of transmissive elements downbeam (in a direction of travel of the forward propagating beam 21) of the polarization means 130 in a path of the forward propagating beam 21 from the source 101 to the droplet 105. In other words, the majority of transmissive elements in a path between the source 101 and the plasma formation region 4 are provided upbeam (relative to a direction of travel of the forward propagating beam 21) of the polarization means 130. The polarization means 130 is more desirably disposed such that a number of transmissive elements upbeam (relative to a direction of travel of the forward propagating beam 21) of the polarization means 130 is greater than a number of transmissive elements downbeam (in a direction of travel of the forward propagating beam 21) of the polarization means 130 in a path of the forward propagating beam 21 from the beam-pickup element 106 to the droplet 105. With these arrangements, the primary return beam 22 is formed of light which has undergone polarization by the polarization means 130, whereas the majority of ghost reflections 23 are likely to be generated by reflections of light which has not undergone polarization by the polarization means 130. The influence of ghost reflections 23 on the measurement of the return beam detector 102 may therefore be reduced as the ghost reflections 23 can be distinguished from the primary return beam 22 based on polarization.

In contrast to the arrangement of Figure 11, in the arrangement of Figure 13 the polarization means 130 is disposed within the optical assembly 30 comprising a plurality of the optical elements 103. In an alternative arrangement, the polarization means 130 may be disposed the optical assembly 30 downbeam (in a direction of travel of the forward propagating beam 21) of the the optical assembly 30.

The number of transmissive elements in the path of the forward propagating beam 21 between the polarization means 130 and the plasma formation region 4 is preferably less than 5, more preferably less than two, and yet more preferably zero. In other words, it is desirable that a number of optical elements 103 which may cause ghost reflections 23 provided in a path of the forward propagating beam 21 between the polarization means 130 and the droplet 105 is as few as possible for the given application, and in the ideal scenario is zero. In this way, light which has undergone polarization to be the desired polarization, and which is travelling towards the droplet 105, may not encounter transmissive elements which could cause ghost reflections 23. Thus, the only ghost reflections 23 would be formed of light which is not of the desired polarization. The ghost reflections 23 and the primary return beam 22 would therefore be of different polarization. Consequently, the ghost reflections 23 and the primary return beam 22 may desirably be distinguished from each other based on polarization.

The polarization means 130 may, for example, be configured to provide a circular polarization to the light being emitted from the source 101. In other words, the polarization means 130 may polarize the forward propagating beam 21 such that the forward propagating beam 21 has circular polarization downbeam (in a direction of travel of the forward propagating beam 21) of the polarization means 130. The light emitted from the source 101 may, for example, be linearly polarized. In other words, the forward propagating beam 21 may have linear polarization upbeam (relative to a direction of travel of the forward propagating beam 21) of the polarization means 130. Therefore, any ghost reflections 23 caused by reflection of this linearly polarized light from an optical element 103 upbeam (relative to a direction of travel of the forward propagating beam 21) of the polarization means 130, would also be linearly polarized. On the other hand, the primary return beam 22 would circularly polarized due to being formed of light that has passed through the polarization means 130. Thus, the majority of ghost reflections 23 would be linearly polarized and could therefore be distinguished from the circularly polarized primary return beam 22. With this arrangement, the measurements from the return beam detector 102 may desirably be able to provide more reliable and accurate information regarding the beam because the ghost reflections 23 can be appropriately filtered out.

The optical system may, for example, further comprise a dichroic window (not shown). The dichroic window is desirably configured to transmit light of the unique wavelength and desired polarization, and to block light of any other polarization. A dichroic window such as this is preferably disposed adjacent to the intended destination and/or adjacent to the return beam detector 102. In other words, a dichroic window may be provided in a path of the forward propagating beam 21 upbeam (relative to a direction of travel of the forward propagating beam 21) of the plasma formation region 4 to ensure that the light reaching the droplet is formed of the desired wavelength and polarization, such that the desired plasma beam output is generated.

Alternatively, or additionally, a dichroic window may be provided in a path of the primary return beam 22 to ensure that the light reaching the return beam detector 102 is formed of the desired wavelength and polarization, such that the return beam detector 102 only receives light which has undergone polarization by the polarization means 130. For example, the dichroic window may be disposed directly upbeam (relative to a direction of travel of the primary return beam 22) of the return beam detector 102. This means that the light received by the return beam detector 102 will desirably include the primary return beam 22 but not include a majority of ghost reflections 23. For example, in an arrangement where the light emitted from the source 101 is linearly polarized and the polarization means 130 is configured to provide a circular polarization, the dichroic window may desirably be configured to transmit light of a circular polarization and to block light of any other polarization.

As shown in the arrangement of Figure 13, the polarization means 130 may be formed of a coating over a surface of one of the plurality of optical elements 103. The coating may be configured to provide the desired polarization to the light being emitted from the source 101, such that downbeam (in a direction of travel of the forward propagating beam 21) of the polarization means 130 the forward propagating beam 21 has the desired polarization. The optical element 103 on which the coating is provided may, for example, be a transmissive element. According to one example, the optical element 103 on which the coating is provided is a mirror. The polarization means 130 may comprise the coating over a surface of the mirror. The surface of the mirror is desirably a downbeam surface (in a direction of travel of the forward propagating beam 21). By providing the polarization means 130 as a coating on one of the optical elements 103 of the optical system, there may be an efficient use of space and components. In other words, this arrangement avoids the time and complexity of redesigning an optical system to include the polarization means 130 as a separate component, and also avoids the space taken by this separate component within the system.

The optical element 103 on which the coating is applied is desirably a most downbeam optical element 103 of the system in a direction of travel of the forward propagating beam 21. The optical element 103 on which the coating is applied may be adjacent the plasma forming region 4. In other words, the optical element 103 on which the coating is applied is desirably a final optical element 103 the forward propagating beam 21 will encounter before being incident on a droplet 105. In this way, there is a reduced likelihood of any ghost reflections 23 being formed of light having the desired polarization. As such, the ability to distinguish the primary return beam 22 which has been reflected off the droplet 105, from the ghost reflections 23, based on polarization may be improved.

In a further arrangement, the polarization means may be provided by a plurality of polarization components. The polarization components of the plurality of polarization components are desirably all disposed in a path of the forward propagating beam 21 between the A beam-pickup element 106 and the plasma forming region 4, where the forward propagating beam 21 is incident on the droplet 105. Each of the plurality of polarization components may contribute to enable the plurality of polarization components together to achieve the polarization effect of the polarization means 130. In other words, the plurality of polarization components may be provided instead of a quarter wave plate or a coating. The plurality of polarization components may, for example, comprise a half-wave plate and a phase retarding mirror. The use of a plurality of polarization components may provide design flexibility and to enable efficient use of different components to achieve the desired effect in limited space.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical, and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Embodiments include the following numbered clauses:
1. An optical system comprising a plurality of transmissive and reflective elements arranged to transmit light of a unique wavelength from a source to an intended destination, wherein
   the source is configured to emit the light as a forward propagating beam, wherein the forward propagating beam follows a path through the transmissive elements and towards a droplet;
   wherein the forward propagating beam is partially reflected on one or more of the transmissive elements and/or the droplet to form a return beam travelling along a path in a generally opposing direction to the forward propagating beam;
   the optical system further comprising a controller configured to:
      measure a first amount of light of the return beam when the system is in an OFF-droplet condition, wherein in the OFF-droplet condition the system is configured such that the forward propagating beam is not incident on a droplet;
      measure a second amount of light of the return beam when the system is in the ON-droplet condition, wherein in the ON-droplet condition the system is configured such that the forward propagating beam is incident on a droplet;
      estimate an amount of ghosting light based on the first amount of light; and
      calibrate subsequent measurements of the second amount of light taken by the system based on the estimated amount of stray ghosting light.
2. The optical system of clause 1, wherein the controller is configured to:
   measure a plurality of first amounts of light corresponding to different powers of forward propagating beam,
   measure a plurality of second amounts of light corresponding to the different powers of forward propagating beam;
   estimate the amount of stray ghosting light based on each corresponding first amount of light, corresponding to the same power of forward propagating beam; and
   calibrate subsequent measurements of the second amount of light taken by the system based on the estimated amount of stray ghosting light as function of power of the forward propagating beam.
3. The optical system of either of clauses 1 and 2, wherein the controller is configured to:
   measure a plurality of first amounts of light corresponding to different amounts of forward propagating beam drift,
   measure a plurality of second amounts of light corresponding to the different amounts of forward propagating beam drift;
   estimate the amount of stray ghosting light based on each corresponding first amount of light, corresponding to the same amount of forward propagating beam drift; and
   calibrate subsequent measurements of the second amount of light taken by the system based on the estimated amount of stray ghosting light as function of amount of forward propagating beam drift.
4. The optical system of any of clauses 1 to 3, wherein the controller is configured to:
   measure a plurality of first amounts of light corresponding to different amounts of forward propagating beam actuation angle,
   measure a plurality of second amounts of light corresponding to the different amounts of forward propagating beam actuation angle;
   estimate the amount of stray ghosting light based on each corresponding first amount of light, corresponding to the same amount of forward propagating beam actuation angle; and
   calibrate subsequent measurements of the second amount of light taken by the system based on the estimated amount of stray ghosting light as function of amount of forward propagating beam actuation angle.
5. The optical system of any of clauses 1 to 4, wherein the controller is configured to:
   measure a plurality of first amounts of light corresponding to different control applied to the forward propagating beam subsequent to the droplet,
   measure a plurality of second amounts of light corresponding to the different control applied to the forward propagating beam subsequent to the droplet;
   estimate the amount of stray ghosting light based on each corresponding first amount of light, corresponding to the same control applied to the forward propagating beam subsequent to the droplet; and
   calibrate subsequent measurements of the second amount of light taken by the system based on the estimated amount of stray ghosting light as function of control applied to the forward propagating beam subsequent to the droplet.
6. The optical system of clause 5, wherein the control applied to the forward propagating beam subsequent to the droplet is a change of one or more of power, curvature, pointing and/or positioning of the forward propagating beam.
7. A method of calibrating measurements of an optical system, wherein the optical system comprises a plurality of transmissive and reflective elements arranged to transmit light of a unique wavelength from a source to an intended destination, wherein
   the source is configured to emit the light as a forward propagating beam, wherein the forward propagating beam follows a path through the transmissive elements and towards a droplet;
   wherein the forward propagating beam is partially reflected on one or more of the transmissive elements and/or the droplet to form a return beam travelling along a path in a generally opposing direction to the forward propagating beam;
   the method comprising:
      measuring a first amount of light of the return beam when the system is in an OFF-droplet condition, wherein in the OFF-droplet condition the system is configured such that the forward propagating beam is not incident on a droplet;
      measuring a second amount of light of the return beam when the system is in the ON-droplet condition, wherein in the ON-droplet condition the system is configured such that the forward propagating beam is incident on a droplet;
      estimating an amount of ghosting light based on the first amount of light; and
      calibrating the measurement of the second amount of light taken by the system based on the estimated amount of stray ghosting light.
8. An optical system comprising a plurality of transmissive elements arranged to transmit light of a unique wavelength from a source to an intended destination, wherein
   the source is configured to emit the light as a forward propagating beam, wherein the forward propagating beam follows a path through the transmissive elements and towards a droplet;
   the forward propagating beam is partially reflected on one or more of the transmissive elements to form a ghost reflection;
   the forward propagating beam is partially reflected on the droplet to form a primary return beam;
   the primary return beam and the ghost reflection form a return beam travelling along a path in a generally opposing direction to the forward propagating beam; and
   wherein the optical system is configured to distinguish between the primary return beam and the ghost reflection based on curvature of the light of the return beam.
9. The optical system of clause 8, further comprising:
   a wavefront sensor configured to measure an optical wavefront of the light of the return beam; and
   a controller configured to:
      receive image data based on measurements from the wavefront sensor, wherein the image data comprises a plurality of pixels each associated with a respective amplitude of the Fourier transform of measurement from the wavefront sensor;
      normalize the amplitudes associated with the pixels in the image;
      find the pixel having the greatest amplitude;
      set a predetermined radius around the pixel having the greatest amplitude;
      identify pixels which are outside of the predetermined radius and have an amplitude greater than a predetermined threshold; and
      filter out data associated with the identified pixels.
10. The optical system of clause 9, wherein filtering out data associated with the identified pixels comprises setting the amplitude of the identified pixels to zero.
11. The optical system of either of clauses 8 and 9, wherein the controller is configured, after setting the predetermined radius, to set the amplitude of pixels within the predetermined radius to zero.
12. The optical system of any of preceding clauses 9 to 11, wherein the predetermined radius is set such that pixel outside the predetermined radius correspond to a curvature of light greater than +3 1/m or less than -3 1/m.
13. A method of operating an optical system, wherein the optical system comprises a plurality of transmissive elements arranged to transmit light of a unique wavelength from a source to an intended destination, wherein the method comprises
   emitting the light from the source as a forward propagating beam, wherein the forward propagating beam follows a path through the transmissive elements and towards a droplet;
   wherein the optical system is configured such that
      the forward propagating beam is partially reflected on one or more of the transmissive elements to form a ghost reflection, and the forward propagating beam is partially reflected on the droplet to form a primary return beam, and
      the primary return beam and the ghost reflection form a return beam travelling along a path in a generally opposing direction to the forward propagating beam; and
   distinguishing between the primary return beam and the ghost reflection based on curvature of the light of the return beam.
14. An optical system comprising a plurality of transmissive elements arranged to transmit light of a unique wavelength from a source to an intended destination, wherein
   the source is configured to emit the light as a forward propagating beam, wherein the forward propagating beam follows a path through the transmissive elements and towards a droplet;
   the forward propagating beam is partially reflected on one or more of the transmissive elements to form a ghost reflection;
   the forward propagating beam is partially reflected on the droplet to form a primary return beam;
   the primary return beam and the ghost reflection form a return beam travelling along a path in a generally opposing direction to the forward propagating beam; and
   wherein the optical system is configured to at least partially suppress the ghost reflection in the return beam.
15. The optical system of clause 14, further comprising an optical element configured to at least partially suppress the light of the ghost reflection without entirely suppressing the light of the primary return beam.
16. The optical system of clause 15, wherein the optical element is disposed at a beam waist location at which light of the ghost reflection is incident.
17. The optical system of clause 16, wherein the beam waist location is a location at which light of the primary return beam is not incident.
18. The optical system of any of clauses 15 to 17, wherein the optical element is configured to absorb and/or diffract and/or reflect and/or scatter light of the ghost reflection.
19. The optical system of any of clause 18, wherein the optical element comprises an optical black light absorbing coating configured to block light of the ghost reflection.
20. The optical system of any of clauses 15 to 19, wherein the optical element is disposed on one of the transmissive elements.
21. The optical system of any of clause 18, wherein the optical element comprises a diffraction structure configured to diffract light of the ghost reflection.
22. The optical system of clause 21, wherein the diffraction structure is a linear grating or a circular grating or a phase grating configured to diffract light of the ghost reflection.
23. The optical system of clause 21, wherein the diffraction structure is convex lens which is comprised of a plurality of parts separated by parallel gaps, wherein the transmissive elements comprise the convex lens.
24. The optical system of clause 23, wherein the plurality of parts includes a central part disposed between at least two other parts, wherein the central part comprises a further optical element configured to at least partially suppress the light of the ghost reflection without entirely suppressing the light of the primary return beam.
25. The optical system of clause 24, wherein the further optical element is an optical black configured to block the light of the ghost reflection.
26. The optical system of clause 18, wherein the optical element comprises a tilted reflective surface or an internal wedge configured reflect light of the ghost reflection in a pre-defined direction.
27. The optical system of any of clauses 15 to 26, comprising a plurality of optical elements, wherein each optical element is configured to at least partially suppress the light of the ghost reflection without entirely suppressing the light of the primary return beam.
28. The optical system of clause 27, wherein the plurality of optical elements comprises at least one optical filter corresponding to each transmissive element.
29. The optical system of clause 15, wherein the optical element is configured to deflect light of the ghost reflection in a different direction than light of the primary return beam, wherein the light of the ghost reflection has a higher curvature than the light of the primary return beam.
30. The optical system of clause 29, wherein the optical element is configured to deflect light of the ghost reflection to exit the optical element at an angle to the optical axis greater than an angle optical axis at which the light of the primary return beam exits the optical element.
31. The optical system of either of clauses 29 and 30, wherein the optical element is a conical element or a collective lens.
32. The optical system of any of clauses 15 to 30, wherein the optical element is configured to be actuated to at least partially suppress the light of the ghost reflection.
33. The optical system of clause 32, wherein the optical element is configured to be actuated in at least one translational direction.
34. The optical system of either of clauses 32 and 33, wherein the optical element is configured to be actuated based on a change of path of the forward propagating beam.
35. The optical system of any of clauses 32 to 34, further comprising a controller configured to control a power and/or path of the forward propagating beam,
   wherein the optical element is configured to be actuated based on feedback from the controller.
36. The optical system of any of clauses 32 to 35, wherein the optical element is disposed on a motorised stage.
37. The optical system of any of clauses 25 to 36, further comprising a heat management system configured to reduce the temperature of the optical element.
38. The optical system of clause 37, wherein the heat management system is configured to circulate fluid to reduce the temperature of the optical element.
39. The optical system of clause 38, wherein the fluid is mercury or tin.
40. An optical system comprising a plurality of transmissive elements arranged to transmit light of a unique wavelength from a source to an intended destination, wherein
   the source is configured to emit the light as a forward propagating beam, wherein the forward propagating beam follows a path through the transmissive elements, wherein the optical system is configured such that the forward propagating beam is incident on a droplet;
   the transmissive elements comprising:
      a polarization means configured to provide a desired polarization to the light being emitted from the source, such that downbeam of the polarization means the forward propagating beam has the desired polarization,
      wherein the polarization means is disposed such that a number of transmissive elements upbeam of the polarization means is greater than a number of transmissive elements downbeam of the polarization means in a path of the forward propagating beam from the source to the droplet.
41. The optical system of clause 40, wherein the desired polarization is circular polarization.
42. The optical system of either of clauses 40 and 41, further comprising a dichroic window adjacent to the intended destination, wherein the dichroic window is configured to transmit light of the unique wavelength and desired polarization towards the intended destination, and to block light of any other polarization.
43. The optical system of any of clauses 40 to 42, wherein the forward propagating beam is partially reflected on one or more of the transmissive elements and/or the droplet to form a return beam travelling along a path in a generally opposing direction to the forward propagating beam;
   the optical system further comprising a dichroic window disposed in a path of the return beam, wherein the dichroic window is configured to transmit light of the desired polarization and to block light of any other polarization.
44. The optical system of any of clauses 40 to 43, wherein the number of transmissive elements in the path of the forward propagating beam between the polarization means and the droplet is less than two.
45. The optical system of clause 44, wherein the number of transmissive elements in the path of the forward propagating beam between the polarization means and the droplet is zero.
46. The optical system of any of clauses 40 to 45, wherein the transmissive elements comprise a mirror; wherein the polarization means comprises a coating over a surface of the mirror, wherein the coating is configured to provide the desired polarization to the light being emitted from the source, such that downbeam of the polarization means the forward propagating beam has the desired polarization.
47. The optical system of any of clauses 40 to 46, wherein the polarization means comprises a quarter wave plate.
48. The optical system of any of clauses 40 to 45, wherein the polarization means is a quarter wave plate.
49. An extreme ultraviolet based lithography system comprising an optical system according to any of clauses 1 to 6, 8 to 12, and 14 to 48.

## Claims

1. An optical system comprising a plurality of transmissive and reflective elements arranged to transmit light of a unique wavelength from a source to an intended destination, wherein
the source is configured to emit the light as a forward propagating beam, wherein the forward propagating beam follows a path through the transmissive elements and towards a droplet;
wherein the forward propagating beam is partially reflected on one or more of the transmissive elements and/or the droplet to form a return beam travelling along a path in a generally opposing direction to the forward propagating beam;
the optical system further comprising a controller configured to:
measure a first amount of light of the return beam when the system is in an OFF-droplet condition, wherein in the OFF-droplet condition the system is configured such that the forward propagating beam is not incident on a droplet;
measure a second amount of light of the return beam when the system is in the ON-droplet condition, wherein in the ON-droplet condition the system is configured such that the forward propagating beam is incident on a droplet;
estimate an amount of ghosting light based on the first amount of light; and
calibrate subsequent measurements of the second amount of light taken by the system based on the estimated amount of stray ghosting light.

2. The optical system of claim 1, wherein the controller is configured to:
measure a plurality of first amounts of light corresponding to different powers of forward propagating beam,
measure a plurality of second amounts of light corresponding to the different powers of forward propagating beam;
estimate the amount of stray ghosting light based on each corresponding first amount of light, corresponding to the same power of forward propagating beam; and
calibrate subsequent measurements of the second amount of light taken by the system based on the estimated amount of stray ghosting light as function of power of the forward propagating beam.

3. The optical system of either of claims 1 and 2, wherein the controller is configured to:
measure a plurality of first amounts of light corresponding to different amounts of forward propagating beam drift,
measure a plurality of second amounts of light corresponding to the different amounts of forward propagating beam drift;
estimate the amount of stray ghosting light based on each corresponding first amount of light, corresponding to the same amount of forward propagating beam drift; and
calibrate subsequent measurements of the second amount of light taken by the system based on the estimated amount of stray ghosting light as function of amount of forward propagating beam drift.

4. The optical system of any of claims 1 to 3, wherein the controller is configured to:
measure a plurality of first amounts of light corresponding to different amounts of forward propagating beam actuation angle,
measure a plurality of second amounts of light corresponding to the different amounts of forward propagating beam actuation angle;
estimate the amount of stray ghosting light based on each corresponding first amount of light, corresponding to the same amount of forward propagating beam actuation angle; and
calibrate subsequent measurements of the second amount of light taken by the system based on the estimated amount of stray ghosting light as function of amount of forward propagating beam actuation angle.

5. The optical system of any of claims 1 to 4, wherein the controller is configured to:
measure a plurality of first amounts of light corresponding to different control applied to the forward propagating beam subsequent to the droplet,
measure a plurality of second amounts of light corresponding to the different control applied to the forward propagating beam subsequent to the droplet;
estimate the amount of stray ghosting light based on each corresponding first amount of light, corresponding to the same control applied to the forward propagating beam subsequent to the droplet; and
calibrate subsequent measurements of the second amount of light taken by the system based on the estimated amount of stray ghosting light as function of control applied to the forward propagating beam subsequent to the droplet.

6. The optical system of claim 5, wherein the control applied to the forward propagating beam subsequent to the droplet is a change of one or more of power, curvature, pointing and/or positioning of the forward propagating beam.

7. A method of calibrating measurements of an optical system, wherein the optical system comprises a plurality of transmissive and reflective elements arranged to transmit light of a unique wavelength from a source to an intended destination, wherein
the source is configured to emit the light as a forward propagating beam, wherein the forward propagating beam follows a path through the transmissive elements and towards a droplet;
wherein the forward propagating beam is partially reflected on one or more of the transmissive elements and/or the droplet to form a return beam travelling along a path in a generally opposing direction to the forward propagating beam;
the method comprising:
measuring a first amount of light of the return beam when the system is in an OFF-droplet condition, wherein in the OFF-droplet condition the system is configured such that the forward propagating beam is not incident on a droplet;
measuring a second amount of light of the return beam when the system is in the ON-droplet condition, wherein in the ON-droplet condition the system is configured such that the forward propagating beam is incident on a droplet;
estimating an amount of ghosting light based on the first amount of light; and
calibrating the measurement of the second amount of light taken by the system based on the estimated amount of stray ghosting light.

8. An optical system comprising a plurality of transmissive elements arranged to transmit light of a unique wavelength from a source to an intended destination, wherein
the source is configured to emit the light as a forward propagating beam, wherein the forward propagating beam follows a path through the transmissive elements and towards a droplet;
the forward propagating beam is partially reflected on one or more of the transmissive elements to form a ghost reflection;
the forward propagating beam is partially reflected on the droplet to form a primary return beam;
the primary return beam and the ghost reflection form a return beam travelling along a path in a generally opposing direction to the forward propagating beam; and
wherein the optical system is configured to distinguish between the primary return beam and the ghost reflection based on curvature of the light of the return beam.

9. The optical system of claim 8, further comprising:
a wavefront sensor configured to measure an optical wavefront of the light of the return beam; and
a controller configured to:
receive image data based on measurements from the wavefront sensor, wherein the image data comprises a plurality of pixels each associated with a respective amplitude of the Fourier transform of measurement from the wavefront sensor;
normalize the amplitudes associated with the pixels in the image;
find the pixel having the greatest amplitude;
set a predetermined radius around the pixel having the greatest amplitude;
identify pixels which are outside of the predetermined radius and have an amplitude greater than a predetermined threshold; and
filter out data associated with the identified pixels.

10. The optical system of claim 9, wherein filtering out data associated with the identified pixels comprises setting the amplitude of the identified pixels to zero.

11. The optical system of either of claims 8 and 9, wherein the controller is configured, after setting the predetermined radius, to set the amplitude of pixels within the predetermined radius to zero.

12. The optical system of any of preceding claims 9 to 11, wherein the predetermined radius is set such that pixel outside the predetermined radius correspond to a curvature of light greater than +3 1/m or less than -3 1/m.

13. A method of operating an optical system, wherein the optical system comprises a plurality of transmissive elements arranged to transmit light of a unique wavelength from a source to an intended destination, wherein the method comprises
emitting the light from the source as a forward propagating beam, wherein the forward propagating beam follows a path through the transmissive elements and towards a droplet;
wherein the optical system is configured such that
the forward propagating beam is partially reflected on one or more of the transmissive elements to form a ghost reflection, and the forward propagating beam is partially reflected on the droplet to form a primary return beam, and
the primary return beam and the ghost reflection form a return beam travelling along a path in a generally opposing direction to the forward propagating beam; and
distinguishing between the primary return beam and the ghost reflection based on curvature of the light of the return beam.

14. An optical system comprising a plurality of transmissive elements arranged to transmit light of a unique wavelength from a source to an intended destination, wherein
the source is configured to emit the light as a forward propagating beam, wherein the forward propagating beam follows a path through the transmissive elements and towards a droplet;
the forward propagating beam is partially reflected on one or more of the transmissive elements to form a ghost reflection;
the forward propagating beam is partially reflected on the droplet to form a primary return beam;
the primary return beam and the ghost reflection form a return beam travelling along a path in a generally opposing direction to the forward propagating beam; and
wherein the optical system is configured to at least partially suppress the ghost reflection in the return beam.

15. The optical system of claim 14, further comprising an optical element configured to at least partially suppress the light of the ghost reflection without entirely suppressing the light of the primary return beam.

16. The optical system of claim 15, wherein the optical element is disposed at a beam waist location at which light of the ghost reflection is incident.

17. The optical system of claim 16, wherein the beam waist location is a location at which light of the primary return beam is not incident.

18. The optical system of any of claims 15 to 17, wherein the optical element is configured to absorb and/or diffract and/or reflect and/or scatter light of the ghost reflection.

19. The optical system of any of claim 18, wherein the optical element comprises an optical black light absorbing coating configured to block light of the ghost reflection.

20. The optical system of any of claims 15 to 19, wherein the optical element is disposed on one of the transmissive elements.

21. The optical system of any of claim 18, wherein the optical element comprises a diffraction structure configured to diffract light of the ghost reflection.

22. The optical system of claim 21, wherein the diffraction structure is a linear grating or a circular grating or a phase grating configured to diffract light of the ghost reflection.

23. The optical system of claim 21, wherein the diffraction structure is convex lens which is comprised of a plurality of parts separated by parallel gaps, wherein the transmissive elements comprise the convex lens.

24. The optical system of claim 23, wherein the plurality of parts includes a central part disposed between at least two other parts, wherein the central part comprises a further optical element configured to at least partially suppress the light of the ghost reflection without entirely suppressing the light of the primary return beam.

25. The optical system of claim 24, wherein the further optical element is an optical black configured to block the light of the ghost reflection.

26. The optical system of claim 18, wherein the optical element comprises a tilted reflective surface or an internal wedge configured reflect light of the ghost reflection in a pre-defined direction.

27. The optical system of any of claims 15 to 26, comprising a plurality of optical elements, wherein each optical element is configured to at least partially suppress the light of the ghost reflection without entirely suppressing the light of the primary return beam.

28. The optical system of claim 27, wherein the plurality of optical elements comprises at least one optical filter corresponding to each transmissive element.

29. The optical system of claim 15, wherein the optical element is configured to deflect light of the ghost reflection in a different direction than light of the primary return beam, wherein the light of the ghost reflection has a higher curvature than the light of the primary return beam.

30. The optical system of claim 29, wherein the optical element is configured to deflect light of the ghost reflection to exit the optical element at an angle to the optical axis greater than an angle optical axis at which the light of the primary return beam exits the optical element.

31. The optical system of either of claims 29 and 30, wherein the optical element is a conical element or a collective lens.

32. The optical system of any of claims 15 to 30, wherein the optical element is configured to be actuated to at least partially suppress the light of the ghost reflection.

33. The optical system of claim 32, wherein the optical element is configured to be actuated in at least one translational direction.

34. The optical system of either of claims 32 and 33, wherein the optical element is configured to be actuated based on a change of path of the forward propagating beam.

35. The optical system of any of claims 32 to 34, further comprising a controller configured to control a power and/or path of the forward propagating beam,
wherein the optical element is configured to be actuated based on feedback from the controller.

36. The optical system of any of claims 32 to 35, wherein the optical element is disposed on a motorised stage.

37. The optical system of any of claims 25 to 36, further comprising a heat management system configured to reduce the temperature of the optical element.

38. The optical system of claim 37, wherein the heat management system is configured to circulate fluid to reduce the temperature of the optical element.

39. The optical system of claim 38, wherein the fluid is mercury or tin.

40. An optical system comprising a plurality of transmissive elements arranged to transmit light of a unique wavelength from a source to an intended destination, wherein
the source is configured to emit the light as a forward propagating beam, wherein the forward propagating beam follows a path through the transmissive elements, wherein the optical system is configured such that the forward propagating beam is incident on a droplet;
the transmissive elements comprising:
a polarization means configured to provide a desired polarization to the light being emitted from the source, such that downbeam of the polarization means the forward propagating beam has the desired polarization,
wherein the polarization means is disposed such that a number of transmissive elements upbeam of the polarization means is greater than a number of transmissive elements downbeam of the polarization means in a path of the forward propagating beam from the source to the droplet.

41. The optical system of claim 40, wherein the desired polarization is circular polarization.

42. The optical system of either of claims 40 and 41, further comprising a dichroic window adjacent to the intended destination, wherein the dichroic window is configured to transmit light of the unique wavelength and desired polarization towards the intended destination, and to block light of any other polarization.

43. The optical system of any of claims 40 to 42, wherein the forward propagating beam is partially reflected on one or more of the transmissive elements and/or the droplet to form a return beam travelling along a path in a generally opposing direction to the forward propagating beam;
the optical system further comprising a dichroic window disposed in a path of the return beam, wherein the dichroic window is configured to transmit light of the desired polarization and to block light of any other polarization.

44. The optical system of any of claims 40 to 43, wherein the number of transmissive elements in the path of the forward propagating beam between the polarization means and the droplet is less than two.

45. The optical system of claim 44, wherein the number of transmissive elements in the path of the forward propagating beam between the polarization means and the droplet is zero.

46. The optical system of any of claims 40 to 45, wherein the transmissive elements comprise a mirror; wherein the polarization means comprises a coating over a surface of the mirror, wherein the coating is configured to provide the desired polarization to the light being emitted from the source, such that downbeam of the polarization means the forward propagating beam has the desired polarization.

47. The optical system of any of claims 40 to 46, wherein the polarization means comprises a quarter wave plate.

48. The optical system of any of claims 40 to 45, wherein the polarization means is a quarter wave plate.

49. An extreme ultraviolet based lithography system comprising an optical system according to any of claims 1 to 6, 8 to 12, and 14 to 48.
